# EUROPEAN PATENT APPLICATION

(11) **EP 1 909 323 A2**
(43) Date of publication of application: **09.04.2008**
(21) Application number: 07019458.4
(22) Date of filing: 04.10.2007
(51) Int. Cl.: H01L 23/31

(54) **Semiconductor device and method for manufacturing the same**

(30) Priority: 04.10.2006 JP 2006273338
(71) Applicant: SHINKO ELECTRIC INDUSTRIES CO., LTD., Nagano-shi, Nagano 381-2287 (JP)
(72) Inventor: Yamano, Takaharu, Nagano-shi Nagano 381-2287 (JP)
(74) Representative: Zimmermann, Gerd Heinrich

(57) **Abstract**

A semiconductor device 100 includes a first semiconductor chip 101; a multilayer wiring 200 which is formed on the first semiconductor chip and which is connected to the first semiconductor chip; a second semiconductor chip 201 connected to the first semiconductor chip by way of the multilayer wiring; a sealing material 115 which seals the second semiconductor chip; and projecting plugs 112 which are connected to the multilayer wiring and whose extremities become exposed on the sealing material.

## Description

This application is based on and claims priority from Japanese Patent Application No. 2006-273338, filed on Oct. 04, 2006, the entire contents of which are hereby incorporated by reference.

The present disclosure relates to a semiconductor device into which a plurality of semiconductor chips are packaged, and to a method for manufacturing the same.

Various structures have already been proposed in connection with a semiconductor device into which a plurality of semiconductor chips are packaged. For example, there is a semiconductor device having a plurality of semiconductor chips which are stacked on an interposer.

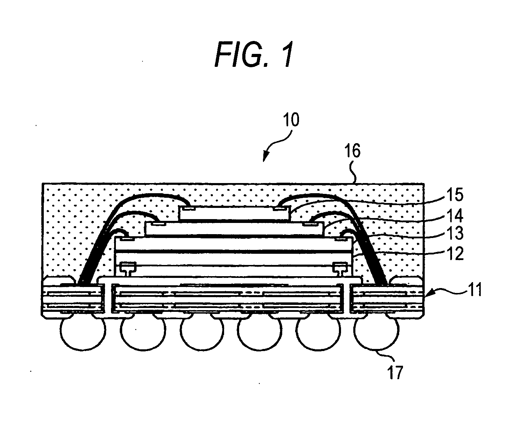

Fig. 1 is a cross sectional view schematically showing a related-art semiconductor device 10 of a chip-stacked type, where a plurality of semiconductor chips are stacked. By reference to Fig. 1, in the semiconductor device 10, semiconductor chips 12 through 15 are stacked on an interposer 11 having a multilayer wiring structure, and the semiconductor chips 12 through 15 are sealed with a sealing material 16 made of an insulating material.

The lower-layer semiconductor chip 12 is bonded to the multilayer wiring formed on the interposer by flip-chip bonding. The upper-layer semiconductor chips 13 through 15 are connected to the multilayer wiring formed on the interposer 11 by wire bonding. For example, see Japanese Unexamined Patent Documents: JP-A-2001-94033 and JP-A-2002-353402.

However, the semiconductor device of the chip-stacked type is mounted on an object to be connected such as a mother board, by way of an interposer. Therefore, there is a problem in downsizing and thinning the semiconductor device. For example, the interposer 11 is formed from a multilayer wiring board having a predetermined thickness and is manufactured through a so-called build-up method or a PWB process (a method for manufacturing a printed wiring board). Thus, there is a problem in downsizing a semiconductor device of chip-stacked type.

The area of the interposer achieved when viewed from above becomes greater than that of the semiconductor chip. Thus, it causes a problem in downsizing the semiconductor device. In a related-art semiconductor device, semiconductor chips stacked as upper layers are connected to the interposer by wire bonding. Hence, space for routing and connection of wire bonding is required, and thus it causes a problem in downsizing a semiconductor device.

In a related-art semiconductor device of chip-stacked type, it is difficult to test respective semiconductor chips before substantive completion of a semiconductor device (before completion of package). There has been the case where a test for checking non-defective products is performed after completion of packaging.

Therefore, even when a portion (e.g., one) of semiconductor chips to be stacked is defective, the entirety of an expensive semiconductor device including a plurality of semiconductor chips becomes defective, and thus there has been raised a problem of decrease in the manufacturing yield of a semiconductor device and increase in manufacturing cost.

For instance, foregoing JP-A-2001-94033 and JP-A-2002-353402 disclose a method for stacking and packaging semiconductor chips without an interposer and a method for stacking semiconductor chips on a substrate.

However, under these related-art methods, it is difficult to particularly handle an increase in the number of pins of a semiconductor chip (a substrate) serving as a lower layer. Further, difficulty is encountered in structures of a semiconductor chip (a substrate) serving substantially as a lower layer (for example, increase in the number of connection sections (e.g., electrode pads)). Therefore, there is a problem of occurrence of a limitation being imposed on the structure of a semiconductor device.

Accordingly, exemplary embodiments provide a new and useful semiconductor device and a method for manufacturing the same.

Further, exemplary embodiments downsize a semiconductor device into which a plurality of semiconductor chips are packaged.

In light of the above, a semiconductor device according to independent claim 1 and a method for manufacturing a semiconductor device according to independent claim 4 are provided.
Further advantages, features, aspects and details of the invention are evident from the dependent claims, the description and the drawings.
According to a first aspect of the present invention, a semiconductor device comprises:
a first semiconductor chip;
a multilayer wiring which is formed on the first semiconductor chip and connected to the first semiconductor chip;
a second semiconductor chip connected to the first semiconductor chip by way of the multilayer wiring;
a sealing material which seals the second semiconductor chip; and
projecting plugs which are connected to the multilayer wiring and whose tip ends are exposed from the sealing material.

According to a second aspect of the present invention, a method for manufacturing a semiconductor device, comprises the steps of:
a) forming a multilayer wiring connected to a first semiconductor chip on an area corresponding to the first semiconductor chip formed on a substrate;
b) forming projecting plugs connected to the multilayer wiring;
c) connecting a second semiconductor chip to the multilayer wiring; and
d) sealing the second semiconductor chip with a sealing material.

According to the first and second aspects of present invention, it is possible to downsize a semiconductor device into which a plurality of semiconductor chips are packaged.
Embodiments are also directed to apparatuses manufactured by the disclosed methods and including apparatus parts corresponding to described method steps. Furthermore, embodiments are also directed to methods by which the described apparatus is manufactured. It may include method steps for manufacturing parts of the apparatus. The method steps may be performed by way of hardware components, firmware, software, a computer programmed by appropriate software, by any combination thereof or in any other manner.

The invention will be better understood by reference to the following description of embodiments of the invention taken in conjunction with the accompanying drawings, wherein:
Fig. 1 is a view showing an example structure of a related-art semiconductor device;
Fig. 2 is a view showing a semiconductor device of a first exemplary embodiment (Part 1);
Fig. 3 is a view showing a second semiconductor device of the first exemplary embodiment (Part 2);
Fig. 4A is a view showing a first process step for fabricating the semiconductor device of the first exemplary embodiment;
Fig. 4B is a view showing a second process step for fabricating the semiconductor device of the first exemplary embodiment;
Fig. 4C is a view showing a third process step for fabricating the semiconductor device of the first exemplary embodiment;
Fig. 4D is a view showing a fourth process step for fabricating the semiconductor device of the first exemplary embodiment;
Fig. 4E is a view showing a fifth process step for fabricating the semiconductor device of the first exemplary embodiment;
Fig. 4F is a view showing a sixth process step for fabricating the semiconductor device of the first exemplary embodiment;
Fig. 4G is a view showing a seventh process step for fabricating the semiconductor device of the first exemplary embodiment;
Fig. 4H is a view showing an eighth process step for fabricating the semiconductor device of the first exemplary embodiment;
Fig. 4I is a view showing a ninth process step for fabricating the semiconductor device of the first exemplary embodiment;
Fig. 4J is a view showing a tenth process step for fabricating the semiconductor device of the first exemplary embodiment;
Fig. 4K is a view showing an eleventh process step for fabricating the semiconductor device of the first exemplary embodiment;
Fig. 4L is a view showing a twelfth process step for fabricating the semiconductor device of the first exemplary embodiment;
Fig. 4M is a view showing a thirteenth process step for fabricating the semiconductor device of the first exemplary embodiment;
Fig. 4N is a view showing a fourteenth process step for fabricating the semiconductor device of the first exemplary embodiment;
Fig. 4O is a view showing a fifteenth process step for fabricating the semiconductor device of the first exemplary embodiment; and
Fig. 4P is a view showing a sixteenth process step for fabricating the semiconductor device of the first exemplary embodiment.

According to a semiconductor device of the present invention, the semiconductor device comprises:
a first semiconductor chip;
a multilayer wiring which is formed on the first semiconductor chip and connected to the first semiconductor chip;
a second semiconductor chip connected to the first semiconductor chip by way of the multilayer wiring;
a sealing material which seals the second semiconductor chip; and
projecting plugs which are connected to the multilayer wiring and whose extremities are exposed from or become exposed on the sealing material.

The above configuration is characterized by having a structure without a multilayer wiring board (so-called an interposer) mounted with a semiconductor device. In this case, the first semiconductor chip and the second semiconductor chip are stacked with the multilayer wiring sandwiched therebetween. Further, the first semiconductor chip and the second semiconductor chip are electrically connected to each other by way of the multilayer wiring.

The projecting plugs used for connecting the semiconductor device to an object to be connected such as a mother board, are formed on the multilayer wiring. The plugs are connected to the first semiconductor chip and the second semiconductor chip by way of the multilayer wiring.

Therefore, the semiconductor device has a characteristic of enabling downsizing and thinning while having a structure in which a plurality of semiconductor chips (the first semiconductor chip and the second semiconductor chip) are packaged. Further, since the first semiconductor chip is connected with the second semiconductor chip through the multilayer wiring, an increase in the number of pins of a semiconductor chip can be applied.

In a semiconductor device of chip-stacked type using a related-art interposer, it is difficult to test chips of respective semiconductor layers before substantive completion of packaging. In the meantime, when the above semiconductor device is manufactured, it is possible to test the first semiconductor chip serving as a lower layer by use of, e.g., the previously-described plugs before mounting of the second semiconductor chip serving as an upper layer. Therefore, the method for manufacturing a semiconductor device of the present invention has an advantage that manufacturing yield is improved and manufacturing cost is reduced.

Next, the configuration of the semiconductor device and an example method for manufacturing the semiconductor device will now be described hereunder with reference to the drawings.

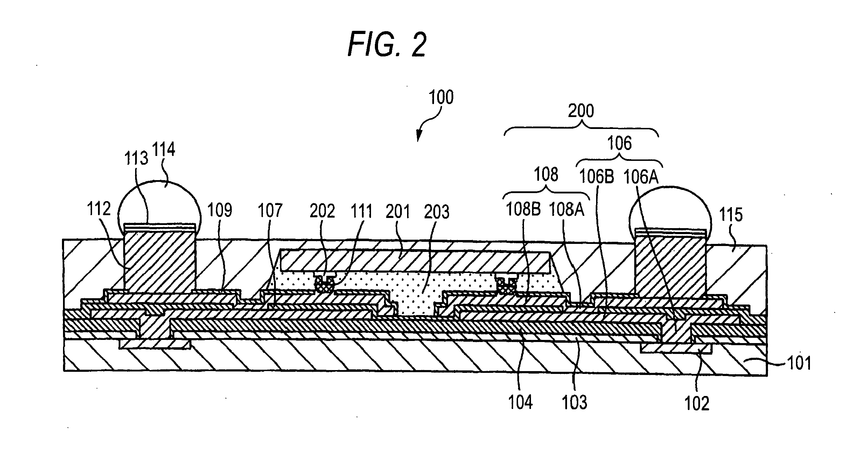

Fig. 2 is a cross sectional view schematically showing a semiconductor device 100 according to a first exemplary embodiment of the present invention. By reference to Fig. 2, the semiconductor device 100 of the present embodiment substantively has a structure in which a first semiconductor chip 101 and a second semiconductor chip 201 are stacked with a multilayer wiring 200 sandwiched therebetween.

The first semiconductor chip 101 is electrically connected to the second semiconductor chip 201 by way of the multilayer wiring 200. The second semiconductor chip 201 is sealed with a sealing resin 115 formed of, e.g., a resin material (a molding resin) on the multilayer wiring 200.

The second semiconductor chip 201 is smaller than the first semiconductor chip 101, and projecting plugs 112 connected to the multilayer wiring 200 are formed on an area of the multilayer wiring 200 located around the second semiconductor chip 201. Tip ends of the respective plugs 112 are formed so as to be exposed from the sealing material 115.

Electrode pads 102 are formed on a device surface, where a device is formed, of the first semiconductor chip 101. The device surface of the first semiconductor chip 101 other than portions on which the electrode pads 102 is formed is protected by a protective layer (a passivation layer) 103.

The multilayer wiring 200 has a lower wiring 106 formed closer to the first semiconductor chip 101 (as a lower layer) and an upper wiring 108 formed closer to the second semiconductor chip 201 (as an upper layer). An insulating layer (an interlayer insulating layer) 107 is formed between the lower wiring 106 and the upper wiring 108, thereby insulating the upper layer and the lower layer from each other. Moreover, an insulating layer 104 is formed between the lower wiring 106 and the protective layer 103. An insulating layer 109 is formed on the upper wiring 108 (i.e., a space between the upper wiring 108 and the sealing material 115), thereby protecting and insulating the wirings.

For instance, the lower wiring 106 is formed so as to have via plugs 106A and a patterned wiring 106B connected to the via plugs 106A. The via plugs 106A are connected to the electrode pads 102 (the first semiconductor chip 101), and the patterned wiring 106B is connected to the upper wiring 108. Likewise, the upper wiring 108 is formed so as to have via plugs 108A and a patterned wiring 108B. The via plugs 108A are connected to the lower wiring 106 (the patterned wiring 106B), and the patterned wiring 108B is connected to the second semiconductor chip 201 and plugs 112.

Bumps 202 are formed on electrode pads (not shown in the drawings) on a device surface, where a device is formed, of the second semiconductor chip 201, and the bumps 202 are electrically connected to the upper wiring 108 (the patterned wiring 108B). Specifically, the second semiconductor chip 201 is bonded to the multilayer wiring 200 by flip-chip bonding. An underfill 203 is filled between the second semiconductor chip 201 and the multilayer wiring 200.

Tip ends of the plugs 112 formed on the upper wiring 108 (the patterned wiring 108B) are exposed from the sealing material 115, and bumps 114 serving as external connection terminals are formed on the respective tip ends by way of a connection layer 113. The first semiconductor chip 101 and the second semiconductor chip 201 are electrically connected to an object to be connected with the semiconductor device 100 (a mounting circuit board) such as a mother board by way of the plugs 112.

For instance, a material described below is used in the above configuration. The electrode pads 102 may be made of Al. The protective layer 103 may be made of SiN (Si₃N₄). The insulating layer 104 may be made of polyimide or an insulating resin material having a similar function. The insulating layers 107 and 109 may be made of an inorganic-based insulating film such as SiO₂. The lower wiring 106, the upper wiring 108 and the plugs 102 may be made of Cu. The connection layer 111 may be made of a multilayer structure made of Ni and a soldering layer (Ni comes closer to an interconnect side). The connection layer 113 may be made of a multilayer structure made of Ni and Au (Ni comes closer to a plug side). The bumps 114 may be made of solder and the sealing material 115 may be made of a resin material such as epoxy. These materials are mere exemplifications, and the present invention is not limited to these materials.

The semiconductor device 100 of the present embodiment has a structure without a multilayer wiring board (a so-called interposer) mounted with a semiconductor device. The structure enables thinning of the semiconductor device. The size (area) of the semiconductor device of the present embodiment achieved when viewed from top is substantively equal to that of the first semiconductor chip 101, thereby realizing downsizing and thinning of semiconductor device. That is, a semiconductor device of the present embodiment is characterized by being equal in size to a chip-size package substantively appropriate to the first semiconductor chip 101 and having a structure in which a plurality of semiconductor chips (the first semiconductor chip 101 and the second semiconductor chip 201) are packaged.

The structure is characterized in that wiring (so-called rewiring) for connecting the first semiconductor chip 101 to the semiconductor chip 201, which is to be stacked one on top of the other, is a multilayer wiring. For example, a semiconductor chip with a logic circuit, which is called a logic-based IC, a System On chip (SoC) or a mixed IC, usually has a large number of connection points (electrode pads) connected to a device, which is a so-called multi-pin structure. The number of connection points tends to increase in accordance with recent high-performance of a semiconductor chip.

Therefore, for example, a related-art connection method for a semiconductor chip (as disclosed in e.g. JP-A-2001-94033, JP-A-2002-353402, and the like) encounters difficulty in handling the multi-pin structure and mounting a semiconductor chip having a high-performance logic circuit.

In the meantime, the semiconductor device 100 of the present embodiment is characterized in that the first semiconductor chip 101 and the second semiconductor chip 201 to be stacked thereon are connected together by means of the multilayer wiring 200, thereby enabling realization of a miniaturized wiring, an increased number of pins and high-performance of a semiconductor chip.

Therefore, a semiconductor chip with an increased number of pins and a high-performance logic circuit, which is called a logic-based IC, an SoC or a mixed IC, can be packaged as the first semiconductor chip 101, for example. Thus, a high-performance semiconductor device can be configured.

Various semiconductor chips can be mounted as a second semiconductor chip 201. However, for example, a memory-based semiconductor chip can be used in combination with the first semiconductor chip 101 having a logic circuit.

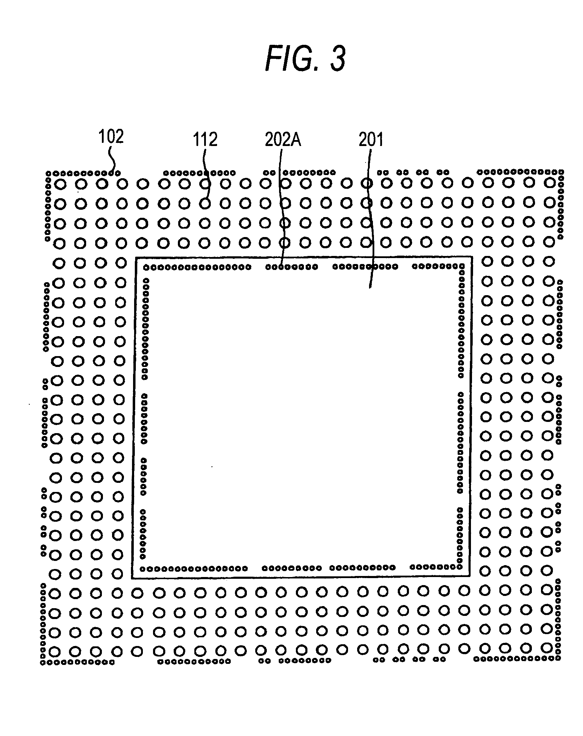

For instance, Fig. 3 shows a positional relationship among the electrode pads 102 of the first semiconductor chip 101, electrode pads 202A of the second semiconductor chip 201, and the plugs 112 achieved when the semiconductor device 100 shown in Fig. 2 is viewed from top.

By reference to Fig. 3, the electrode pads 202A are formed along four rims of the second semiconductor chip 201. The electrode pads 202A are connected to the electrode pads 102 formed along rims of the first semiconductor chip 101 by means of the multilayer wiring 200 (an illustration of the multilayer wiring is omitted from Fig.3 but shown in Fig. 2). Further, the plugs 112 formed so as to stand upright on the multilayer wiring 200 is arranged around the second semiconductor chip 201.

As mentioned above, when the multi-pin semiconductor chip is mounted, it is preferable that electrical connection of a semiconductor chip is established using a multilayer wiring structure as in the present embodiment. Packaging of a miniaturized, high-performance semiconductor chip can be applied using the multilayer wiring structure.

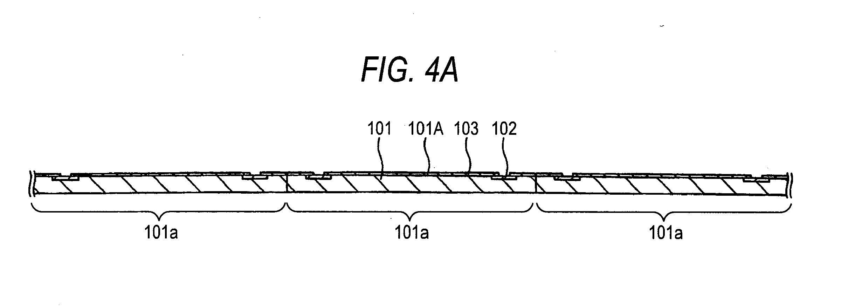

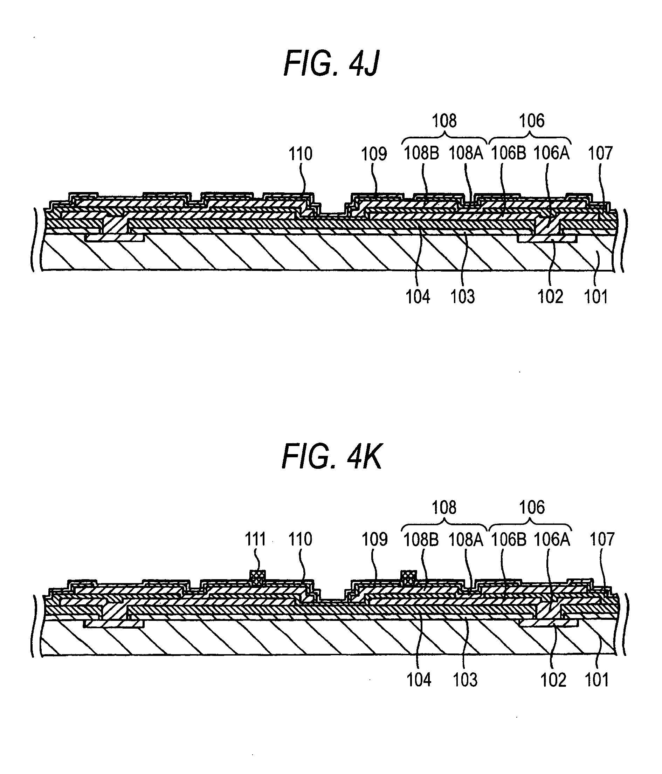

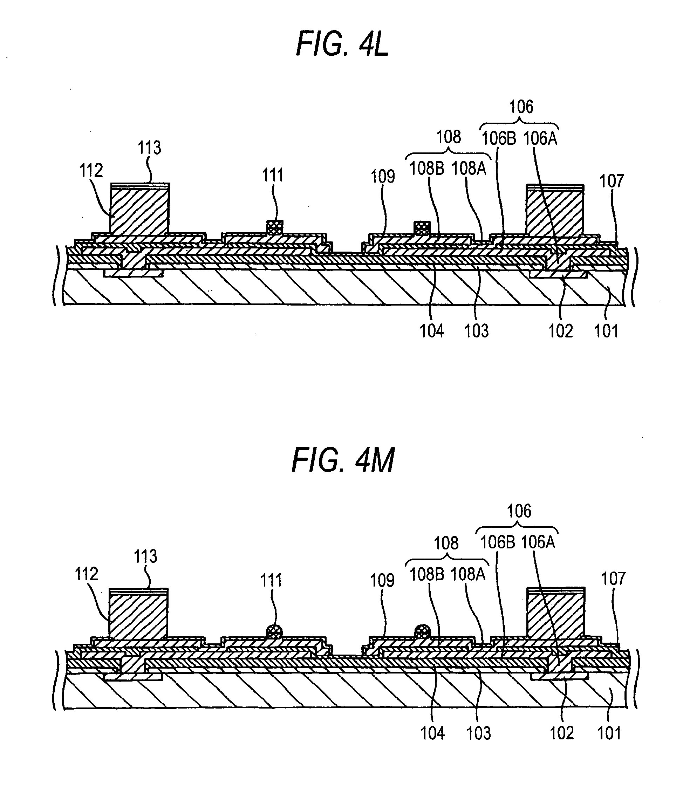

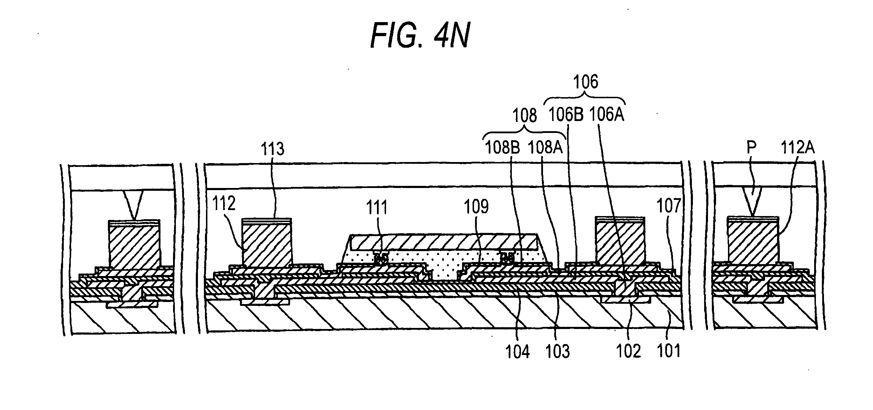

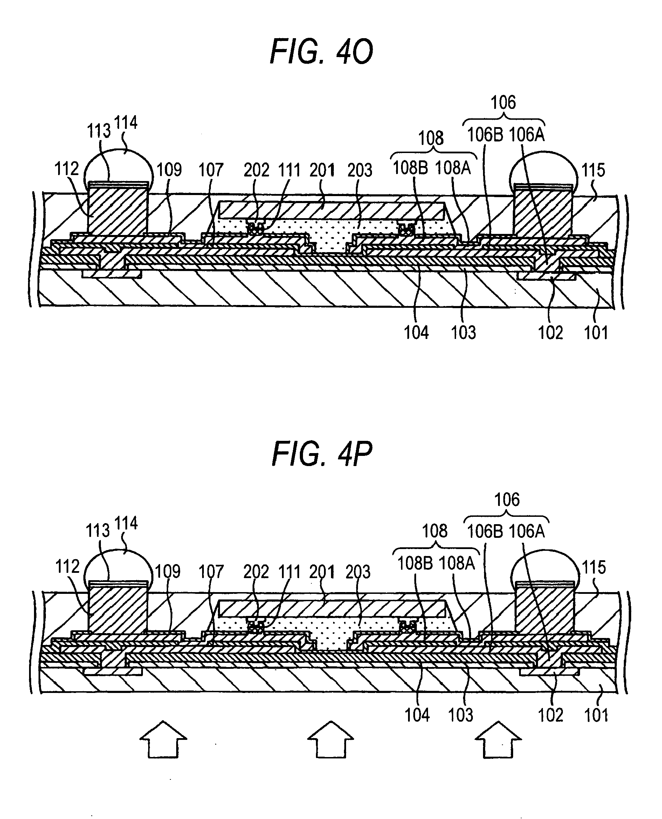

Next, an example method for manufacturing the semiconductor device 100 will be described by reference to Figs. 4A to 4P. In the drawings, there is a case where the elements which have already been described are assigned the same reference numerals and where their repeated explanations are omitted.

First, in a process shown in Fig. 4A, a substrate formed with a plurality of areas 101a each corresponding to the first semiconductor chip 101(e.g., in a grid pattern) is prepared. A multilayer wiring is formed on the areas 101a corresponding to the semiconductor chips 101 through processes to be described later, and the second semiconductor chip 201 is mounted on the multilayer wiring. After passing through such a process, the substrate is cut by means of dicing so that the semiconductor devices (the semiconductor chips 101) are divided into separate semiconductor devices.

The area 101a has a device fabrication surface 101A on which a device is fabricated, and the electrode pads 102 are formed on the device fabrication surface 101 A. An area of the device fabrication surface 101A other than the positions where the electrode pads 102 are formed is protected by a protective layer (a passivation layer) 103 made of, e.g., SiN (Si₃N₄).

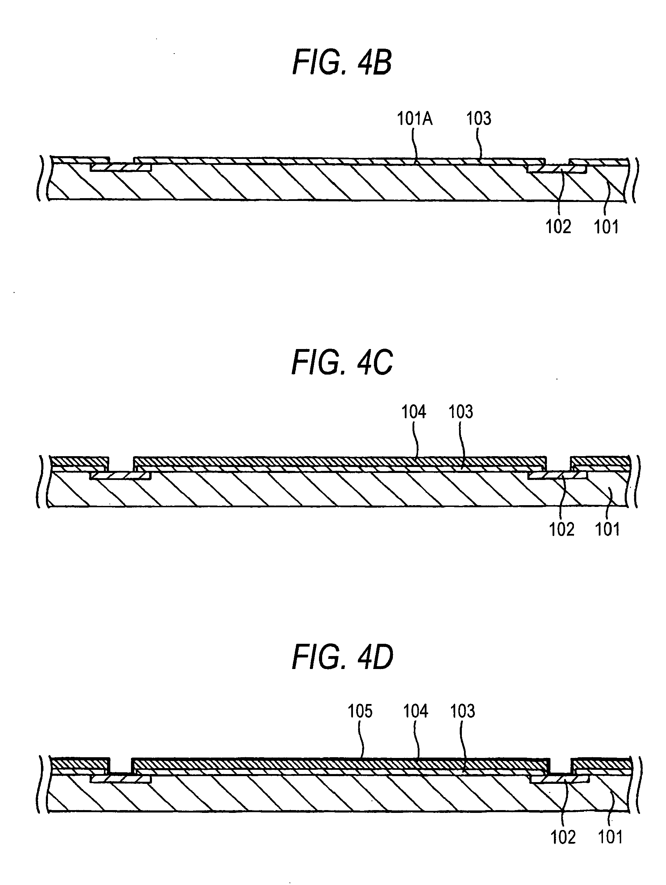

Fig. 4B is a view showing, in an enlarged manner, the area 101a of the substrate shown in Fig. 4A. Fig. 4B and subsequent figures show, as an example, one area 101a in the substrate where the plurality of areas 101a are formed. By reference to the drawings, a method for manufacturing a semiconductor device will be described.

In a process shown in Fig. 4C, an insulating layer 104 made of a resin material such as polyimide, is formed on the protective layer 103. The insulating layer 104 is formed by means of, e.g., lamination or coating. Opening sections from which the electrode pads 102 are exposed are formed in the insulating layer.

In a process shown in Fig. 4D, a seed layer 104 is formed on the insulating layer 104 and the electrode pads 102 by means of a PVD method (e.g., a sputtering method). The seed layer 104 is formed of, e.g., a multilayer structure made of Ti and Cu (Cu comes to be an upper layer) or a multilayer structure made of Cr and Cu (Cu comes to be an upper layer). However, the seed layer 104 is not limited to such a multilayer structure, and can be formed of various materials.

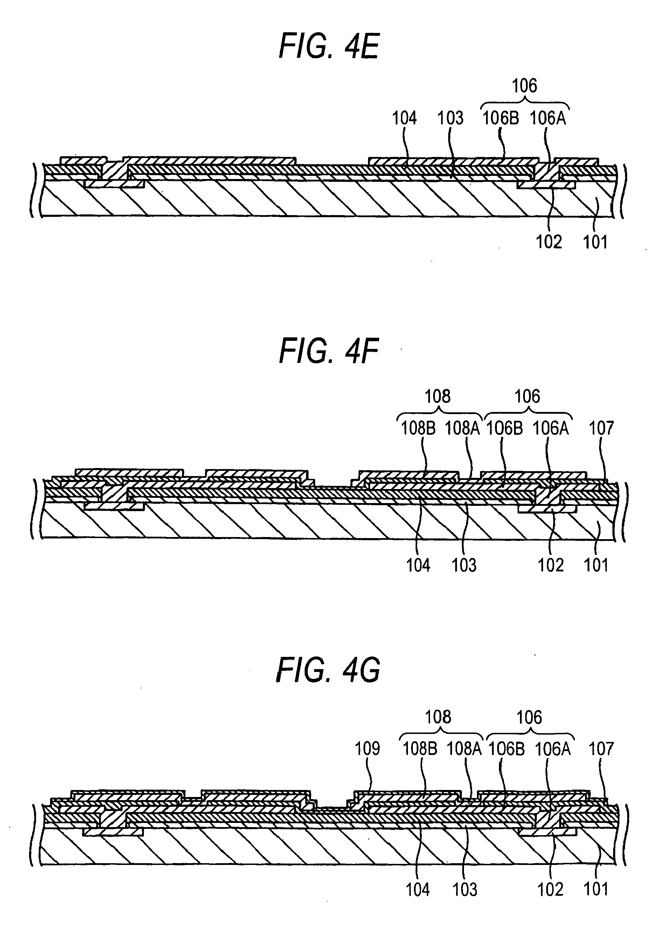

In a process shown in Fig. 4E, the lower wiring 106 having via plugs the 106A and the patterned wiring 106B are formed by means of a so-called, known semi-additive method. At the time of formation of the lower wiring 106, first of all, a photosensitive resist layer is formed on the seed layer 104, and the resist layer is patterned by means of photolithography, thereby forming a resist pattern. Next, while the resist pattern is taken as a mask, the via plugs 106A connected to the electrode pads 102 and the patterned wiring 106B connected to the via plugs 106A are formed by means of electrolytic plating in which the seed layer 104 is taken as a feeding layer, thereby forming the lower wiring 106. After electrolytic plating, the resist pattern is removed, and the resultantly-uncovered seed layer 104 is removed by means of etching, so that a structure shown in Fig. 4E is obtained.

In a process shown in Fig. 4F, the insulating layer 107 made of SiO₂ is formed so as to cover the lower wiring 106 by means of, e.g., CVD. Opening sections from which portions of the lower wiring 106 (the patterned wiring 106B) are exposed, are further formed in the insulating layer 107 by means of pattern etching.

The upper wiring 108 having the via plugs 108A and the patterned wiring 108B is formed in the same manner as in the case of the semi-additive method described by reference to Fig. 4E. At the time of formation of the upper wiring 108, first of all, a seed layer is first formed on the insulating layer 107 by means of sputtering, and a resist pattern is formed on the seed layer. Next, while the resist pattern is taken as a mask, the via plugs 108A connected to the patterned wiring 106B and the patterned wiring 108B connected to the via plugs 108A are formed by means of electrolytic plating in which the seed layer is taken as a feeding layer, thereby forming the upper wiring 108. The resist pattern is removed after electrolytic plating, and the exposed seed layer is removed by means of etching, so that a structure shown in Fig. 4F is obtained.

Next, in a process shown in Fig. 4G, the insulating layer 109 made of SiO₂ is formed so as to cover the upper wiring 108 by means of; e.g., CVD method. Thus, a multilayer wiring can be formed in each of the areas 101a (the first semiconductor chips 101). Further, such a multilayer wiring may be often called rewiring in order to distinguish the wiring from a fine wiring used in a device, such as a logic circuit of the first semiconductor chip 101. The rewiring is generally formed on a protective layer formed on the device surface and differs in size from a fine wiring used in a device.

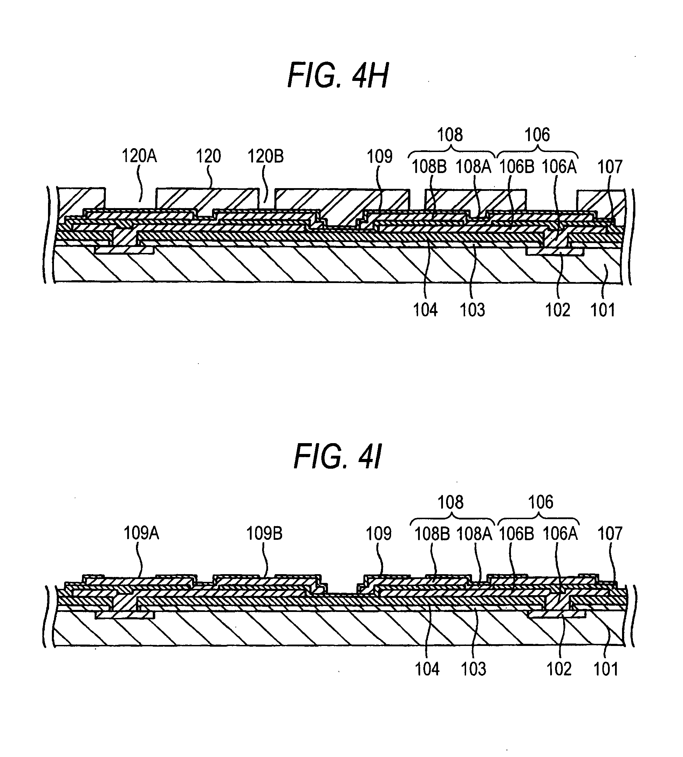

In a process shown in Fig. 4H, a resist pattern 120 having opening sections 120A and 120B is formed on the insulating layer 109. The resist pattern 120 is formed by means of, through photolithography, patterning a resist layer formed by, e.g., lamination or coating. The opening sections 120A correspond to portions bonded with plugs in a subsequent process, and the opening sections 120B correspond to portions bonded to a semiconductor chip by flip-chip bonding.

In a process shown in Fig. 4I, the insulating layer 109 exposed from the opening sections 120A and 120B through, e.g., dry etching or wet etching is removed by means of; e.g., dry etching or wet etching, thereby forming opening sections 109A and 109B in the insulating layer 109. After etching operation, the resist pattern 120 is removed.

Next, in a process shown in Fig. 4J, a seed layer 110 is formed on the insulating layer 109 and the exposed patterned wiring 108B by means of PVD method (e.g., sputtering). The seed layer 110 is formed of, e.g., a multilayer structure made of Ti and Cu (Cu comes to be an upper layer) or a multilayer structure made of Cr and Cu (Cu comes to be an upper layer). However, the seed layer 110 is not limited to these multilayer structures and can be formed from various materials.

In a process shown in Fig. 4K, the connection layer 111 formed of a multilayer structure made of Ni and solder (solder comes to be an upper layer) is formed by means of; e.g., a semi-additive method, as in the case of formation of a multilayer wiring. At the time of formation of the connection layer 111, first of all, a resist pattern is formed on the seed layer 110. Then, while the resist pattern is taken as a mask, the connection layer 111 connected to the patterned wiring 108B is formed by means of electrolytic plating in which the seed layer 110 is taken as a feeding layer. After electrolytic plating, the resist pattern is removed so that a structure shown in Fig. 4L is obtained. Moreover, the seed layer 110 is not removed in this process and still used as a feeding layer in an electrolytic plating process provided below. Specifically, the connection layer 111 formed in this process and the plugs 112 formed in the next process share the common feeding layer 110 used for electrolytic plating.

Next, as in the case of formation of the connection layer 111, in process shown in Fig. 4L, the columnar plugs 112 made of Cu is formed by means of, e.g., a semi-additive method. At the time of formation of the plugs 112, first of all, a resist pattern is first formed on the seed layer 110, and electrolytic plating is performed while the resist pattern is taken as a mask and while the seed layer 110 is taken as a feeding layer, so that the plugs 112 connected to the pattern wiring 108B are formed. After electrolytic plating, the resist pattern is removed, and the exposed seed layer 110 is removed by etching, so that a structure shown in Fig. 4L is obtained. Moreover, in this process, subsequent to formation of the plugs 112, the connection layer 113 formed of a multilayer structure made of Ni and Au (Ni comes closer to the plug 112) may also be formed on the tip ends of the respective plugs 112. The shape of the plug 112 is not limited to a columnar shape, and the plug may also be a different shape; for example, the shape of a quadratic prism, the shape of a triangular prism, and the like.

In a process shown in Fig. 4M, the connection layer 111 is subjected to reflow processing. Alternatively, there may also be provided a process for previously coating the connection layer 111 with flux before the connection layer 111 is subjected to reflow processing. When there is provided a process for coating the connection layer 111 with flux, there may also be provided a process for cleaning the flux after reflow processing.

Subsequently, the second semiconductor chip 201 is mounted on the multilayer wiring. Before mounting of the second semiconductor chip 201, a test for checking whether or not the first semiconductor chips 101 are defective may also be conducted on a wafer (substrate) level.

For instance, in a related-art semiconductor device of chip-stacked type, difficulty is encountered in carrying out a test of an individual semiconductor chip before substantive completion of a semiconductor device. There has been a problem in that a test for checking non-defectives is carried out after completion of packaging operation.

Therefore, even when a portion (e.g., one) of stacked semiconductor chips is defective, the entirety of a packaged semiconductor device becomes defective. Thus, there arises a problem of a decrease in a manufacturing yield of a semiconductor device and a problem of an increase in manufacturing cost.

In the meantime, the method for manufacturing the semiconductor device of the present invention is characterized in that, before mounting of the second semiconductor chip stacked as an upper layer, substantive chip-size packaging of the first semiconductor chips 101 has already been completed. Therefore, a test for checking whether or not the first semiconductor chips 101 are defective can be carried out on a wafer level before mounting of the second semiconductor chip 201.

For instance, a test for only checking non-defective first semiconductor chips 101 may be carried out by bringing a test probe P into contact with the plugs on the multilayer wiring. However, it may also be the case where contacting of the probe P results in occurrence of flaws or indentations in the plugs 112 or the connection layer 113. Hence, as shown in Fig. 4N, the test is preferably conducted by bringing the probe P into contact with test plugs 112A. Specifically, in a process shown in Fig. 4M, it is preferable to previously form the external connection plugs (the plugs 112) for establishing external connection of the semiconductor device and test plugs (the plugs 112A) for testing the first semiconductor chips 101.

In addition to formation of the test plugs 112A, plugs intended for another function such as plugs for heat dissipation purpose, may be also provided in the process shown in Fig. 4M.

Then, the second semiconductor chip 201 is mounted on the multilayer wiring in a process shown in Fig. 40. In this case, the second semiconductor chip 201 formed with bumps 202 is bonded to the upper wiring 108 by way of the connection layer 111 by flip-chip bonding. Moreover, an underfill 203 is filled into a space between the semiconductor chip 201 and the upper wiring 108, and then the underfill 203 is cured.

The second semiconductor chip 201 is sealed as described below. The second semiconductor chip 201 is sealed on the multilayer wiring by means of a sealing material 115 formed of, e.g., an epoxy resin, as the principal ingredient. The tip ends of the plugs 112 (the connection layer 113) may be preferably exposed from the sealing material 115.

Therefore, there may also be provided a process for etching the sealing material 115 by means of plasma (plasma ashing). If necessary, the bumps 114 made of solder are formed on the plugs 112 (the connection layer 113).

Next, in a process shown in Fig. 4P, the back surface of the substrate on which the first semiconductor chips 101 are fabricated are grounded (subjected to back grinding), as necessary, thereby reducing the thickness of the semiconductor chips 101 to a desired thickness. Moreover, processing pertaining to the process for grinding a back surface may also be carried out before formation of the bumps 114.

Then, the semiconductor chips 101 (the semiconductor devices 100) are divided into separate semiconductor chips by means of cutting the substrate through dicing, so that the semiconductor devices 100 shown in Figs. 2 and 3 can be manufactured.

Under the above-mentioned manufacturing method, it is possible to manufacture a semiconductor device which is more miniaturized and thinned when compared with a related-art semiconductor device and is packaged with a plurality of semiconductor chips.

According to the method for manufacturing a semiconductor device, the first semiconductor chips 101 as being a lower layer can be tested before mounting of the second semiconductor chip 201 as being an upper layer. Therefore, the method for manufacturing a semiconductor device of the present invention has an advantage that manufacturing yield is improved and manufacturing cost is reduced.

While the present invention has been described by reference to the preferred embodiment, the present invention is not limited to the above specific embodiment and is susceptible to various modifications or alterations within the scope of the present invention.

For instance, the method for mounting (connecting) the second semiconductor chip 201 is not limited to flip-chip bonding but may also be realized by use of another bonding method such as wire bonding. Moreover, the number of layers consisting a multilayer wiring formed on the first semiconductor chips is not limited to two. The number of layers may also be increased if necessary.

The number of semiconductor chips to be packaged is not limited to two. For instance, semiconductor chips may also be stacked further on the second semiconductor chip.

According to the present invention, a semiconductor device packaged with a plurality of semiconductor chips can be miniaturized.

While there has been described in connection with the exemplary embodiments of the present invention, it will be obvious to those skilled in the art that various changes and modification may be made therein without departing from the present invention. It is aimed, therefore, to cover in the appended claim all such changes and modifications as fall within the true spirit and scope of the present invention.

## Claims

1. A semiconductor device (100) comprising:
a first semiconductor chip (101);
a multilayer wiring (200) which is formed on the first semiconductor chip and connected to the first semiconductor chip;
a second semiconductor chip (201) connected to the first semiconductor chip by way of the multilayer wiring;
a sealing material (115) which seals the second semiconductor chip; and
projecting plugs (112) which are connected to the multilayer wiring and whose tip ends are exposed from the sealing material.

2. The semiconductor device according to claim 1, wherein the first semiconductor chip is a semiconductor chip having a logic circuit, and the second semiconductor chip is a memory-based semiconductor chip.

3. The semiconductor device according to any of claims 1 to 2, wherein the second semiconductor chip (201) is bonded to the multilayer wiring by flip-chip bonding.

4. A method for manufacturing a semiconductor device (100), comprising the steps of:
a) forming a multilayer wiring (200) connected to a first semiconductor chip (101) on an area corresponding to the first semiconductor chip (101a) formed on a substrate;
b) forming projecting plugs (112) connected to the multilayer wiring;
c) connecting a second semiconductor chip (201) to the multilayer wiring; and
d) sealing the second semiconductor chip with a sealing material (115).

5. The method for manufacturing a semiconductor device according to claim 4, further comprising the step of:
e) dividing the first semiconductor chip into separate semiconductor devices by means of dicing the substrate.

6. The method for manufacturing a semiconductor device according to any of claims 4 to 5, wherein the first semiconductor chip (101) is a semiconductor chip having a logic circuit, and the second semiconductor chip (201) is a memory-based semiconductor chip.

7. The method for manufacturing a semiconductor device according to any of claims 4 to 6, wherein the second semiconductor chip is bonded to the multilayer wiring (200) by flip-chip bonding.

8. The method for manufacturing a semiconductor device according to any of claims 4 to 7, further comprising the step of:
f) testing the first semiconductor chips between the step b) and the step c).

9. The method for manufacturing a semiconductor device according to claim 8, wherein, in the step b), there are formed the plurality of plugs including external connection plugs used as external connection terminals and test plugs used in the step f).
